# EUROPEAN PATENT APPLICATION

(11) **EP 3 291 112 A1**
(43) Date of publication of application: **07.03.2018**
(21) Application number: 17157169.8
(22) Date of filing: 21.02.2017
(51) Int. Cl.: G06F 17/50, G06F 9/52

(54) **MASTER AND SLAVE ARCHITECTURE FOR CO-SIMULATION OF CONTROL SYSTEMS**

(30) Priority: 01.09.2016 JP 2016170755
(71) Applicant: Omron Corporation, Kyoto 600-8530 (JP)
(72) Inventor: FUJII, Takashi, Kyoto-shi, Kyoto 600-8530 (JP); NAMIE, Masaki, Kyoto-shi, Kyoto 600-8530 (JP); MANABE, Mikiko, Kyoto-shi, Kyoto 600-8530 (JP)
(74) Representative: Becker Kurig Straus

(57) **Abstract**

A simulator linkage device (10) makes a first simulator (300) and a second simulator (400) execute simulation periodically respectively at a sampling interval set by the user.

## Description

### BACKGROUND OF THE INVENTION

### 1. Field of the Invention

The present invention relates to a simulator linkage device that links simulation executed by multiple simulators respectively.

### 2. Description of Related Art

In the past, a simulation device that links multiple simulators was known. For example, in the following Patent Document 1, a simulator linkage device is described, which, at a time point of receiving a synchronization request message, processes a message sent from a simulator, and sends the processed message to another simulator to be linked.

### Patent Document of the prior art

### Patent Document

Patent Document 1: Japanese Patent Publication Gazette No. 2015-32120 (Gazette on 16 February 2015)

However, the prior art as described above only describes that multiple simulators propel execution of simulation respectively, until at the time of obtaining synchronization predetermined in the multiple simulators respectively, a synchronization request message is notified, and a simulator linkage device, when receiving the synchronization request message, obtains synchronization between the multiple simulators.

Therefore, the simulator linkage device in the prior art has the following problem: simulation executed by multiple simulators respectively is synchronized without making the multiple simulators execute the simulation respectively at a time interval set by a user arbitrarily.

### SUMMARY OF THE INVENTION

The present invention makes multiple simulators execute simulation synchronously at a time interval set by a user respectively.

To solve the problem, a simulator linkage device according to a solution of the present invention includes: an receiving portion that accepts a sampling interval from a user, the sampling interval being an interval at which simulation is executed periodically; a first acquisition portion that acquires a first execution result from a first simulator, the first simulator being a simulator for a controller, and the first execution result being a simulation execution result of an amount of a sampling interval of the first simulator; a second acquisition portion that acquires a second execution result from a second simulator, the second simulator being a simulator for a controlled device controlled by the controller, and the second execution result being a simulation execution result of an amount of a sampling interval of the second simulator; and a synchronization portion that outputs the first execution result acquired by the first acquisition portion to the second simulator, and outputs the second execution result acquired by the second acquisition portion to the first simulator, making the first simulator and the second simulator execute simulation periodically with the sampling interval respectively.

According to the structure, the synchronization portion makes the simulator for the controller, that is, the first simulator and the simulator for a controlled device controlled by the controller, that is, the second simulator, execute simulation periodically at the sampling interval accepted from the user by the receiving portion respectively.

Therefore, the simulator linkage device produces the following effect: the first simulator and the second simulator are enabled to execute simulation synchronously and periodically at the sampling interval accepted from the user by the receiving portion respectively.

For example, the user sets a long time interval as the sampling interval; accordingly, the synchronization portion outputs the first execution result acquired by the first acquisition portion to the second simulator at the sampling interval which is the long time interval, and outputs the second execution result acquired by the second acquisition portion to the first simulator at the sampling interval which is the long time interval. At this point, the synchronization portion can, before the first simulator and the second simulator complete simulation, inhibit the number of sending and receiving of the simulation execution results between the first simulator and the second simulator as a result, which can shorten the execution time of the whole simulation.

Moreover, for example, the user sets a short time interval as the sampling interval; accordingly, the synchronization portion outputs the first execution result acquired by the first acquisition portion to the second simulator at the sampling interval which is the short time interval, and outputs the second execution result acquired by the second acquisition portion to the first simulator at the sampling interval which is the short time interval. At this point, the synchronization portion notifies the second simulator and the first simulator about the result of simulation executed by the first simulator and the second simulator at the short time interval respectively each time. Therefore, compared with a situation of the longer sampling interval, simulation precision of the simulation execution result executed by the first simulator and the second simulator can be improved.

Therefore, the simulator linkage device produces the following effect: the user can arbitrarily choose to attach importance to which one of the execution time of the simulation and the simulation precision of the simulation to execute the simulation.

Preferably, the simulator linkage device further includes: a display portion that displays a control cycle of the controller as an initial set value of the sampling interval.

According to the structure, the display portion displays a control cycle of the controller as an initial set value of the sampling interval.

Therefore, the simulator linkage device produces the following effect: the simulator for the controller, that is, the first simulator, is enabled to execute simulation with the control cycle of the controller, and the simulator for a controlled device controlled by the controller, that is, the second simulator, is enabled to execute simulation synchronously with the simulation of the first simulator.

Preferably, in the simulator linkage device, the sampling interval may be set to a time longer than the control cycle of the controller.

According to the structure, the synchronization portion outputs the first execution result acquired by the first acquisition portion to the second simulator at the sampling interval, the sampling interval being a time longer than the control cycle of the controller, and outputs the second execution result acquired by the second acquisition portion to the first simulator at the sampling interval accepted by the receiving portion.

Therefore, the synchronization portion produces the following effect: before the first simulator and the second simulator complete simulation, the number of sending and receiving of the simulation execution results between the first simulator and the second simulator can be inhibited. That is, the simulator linkage device produces the following effect: the time during which the first simulator and the second simulator complete simulation can be shortened.

Preferably, in the simulator linkage device, the synchronization portion, before the first simulator executes simulation, outputs a variable to the first simulator only once, the variable is a variable used by simulation in the first simulator, and a variable whose value does not change due to execution of the simulation in the first simulator.

According to the structure, the synchronization portion, before the first simulator executes simulation, outputs a variable to the first simulator only once, the variable is a variable used by simulation in the first simulator, and a variable whose value does not change due to execution of the simulation in the first simulator.

Therefore, the synchronization portion produces the following effect: a amount of data sent and received between the first simulator and the second simulator can be inhibited. That is, the simulator linkage device produces the following effect: the time during which the first simulator and the second simulator complete simulation can be shortened.

Preferably, in the simulator linkage device, the receiving portion accepts, from the user, a sampling interval of each variable used when the first simulator or the second simulator executes simulation.

According to the structure, the synchronization portion, at a sampling interval set for each variable used when the first simulator or the second simulator executes simulation, makes the variable sent and received between the first simulator and the second simulator.

Therefore, the simulator linkage device produces the following effect: a variable can be sent and received between the first simulator and the second simulator by taking each variable used when the first simulator or the second simulator executes simulation as an optimal time interval, which can thus shorten the time during which the first simulator and the second simulator complete simulation.

Herein, for example, when the controller executes multiple processing in parallel, the receiving portion can accept sampling intervals from the user respectively for multiple simulation executed by the first simulator corresponding to the multiple processing. Moreover, the synchronization portion outputs respective simulation execution results of the multiple simulation to the second simulator at the respective sampling intervals of the multiple simulation.

Therefore, the simulator linkage device produces the following effect: by outputting respective simulation execution results of the multiple simulation executed by the first simulator in parallel to the second simulator at an interval optimal for each of the multiple simulation, the time during which the first simulator and the second simulator complete simulation can be shortened.

Preferably, the simulator linkage device is formed as a device integrated with the second simulator.

According to the structure, the following effect is produced: the simulator linkage device formed as a device integrated with the second simulator enables the first simulator to synchronously and periodically execute simulation with the simulation of the second simulator at the sampling interval accepted by the receiving portion from the user.

Moreover, to solve the problem, a control method according to a solution of the present invention is a control method of a simulator linkage device that links simulation executed by multiple simulators respectively, wherein the control method includes: an accepting step of accepting a sampling interval from a user, the sampling interval being an interval at which simulation is executed periodically; a first acquisition step of acquiring a first execution result from a first simulator, the first simulator being a simulator for a controller, and the first execution result being a simulation execution result of an amount of a sampling interval of the first simulator; a second acquisition step of acquiring a second execution result from a second simulator, the second simulator being a simulator for a controlled device controlled by the controller, and the second execution result being a simulation execution result of an amount of a sampling interval of the second simulator; and a synchronization step of outputting the first execution result acquired by the first acquisition step to the second simulator, and outputting the second execution result acquired by the second acquisition step to the first simulator, making the first simulator and the second simulator execute simulation periodically with the sampling interval respectively.

According to the method, the synchronization step makes the simulator for the controller, that is, the first simulator and the simulator for a controlled device controlled by the controller, that is, the second simulator, execute simulation periodically at the sampling interval accepted from the user in the accepting step respectively.

Therefore, the control method produces the following effect: the first simulator and the second simulator are enabled to execute simulation synchronously and periodically at the sampling interval accepted from the user in the accepting step respectively.

For example, the user sets a long time interval as the sampling interval; accordingly, the synchronization step outputs the first execution result acquired in the first acquisition step to the second simulator at the sampling interval which is the long time interval, and outputs the second execution result acquired in the second acquisition step to the first simulator at the sampling interval which is the long time interval. At this point, the synchronization step can, before the first simulator and the second simulator complete simulation, inhibit the number of sending and receiving of the simulation execution results between the first simulator and the second simulator as a result, which can shorten the execution time of the whole simulation.

Moreover, for example, the user sets a short time interval as the sampling interval; accordingly, the synchronization step outputs the first execution result acquired in the first acquisition step to the second simulator at the sampling interval which is the short time interval, and outputs the second execution result acquired in the second acquisition step to the first simulator at the sampling interval which is the short time interval. At this point, the synchronization step notifies the second simulator and the first simulator about the result of simulation executed by the first simulator and the second simulator at the short time interval respectively each time. Therefore, compared with a situation of the longer sampling interval, simulation precision of the simulation execution result executed by the first simulator and the second simulator can be improved.

Therefore, the control method produces the following effect: the user can arbitrarily choose to attach importance to which one of the execution time of the simulation and the simulation precision of the simulation to execute the simulation.

The present invention produces the following effect: multiple simulators are enabled to execute simulation synchronously respectively at a time interval set by a user.

### BRIEF DESCRIPTION OF THE DRAWINGS

Fig. 1 is a structural block diagram of main parts of a simulator linkage device according to Embodiment 1 of the present invention.
Fig. 2 is a diagram of an example of a simulation system including the simulator linkage device of Fig. 1.
Fig. 3 is a flowchart of processing flows of a first simulator, a second simulator and a simulator linkage device in the simulation system of Fig. 2.
Fig. 4 is a diagram of an example in which the simulator linkage device of Fig. 1 displays an interval at which simulation is executed periodically, that is, a sampling interval, to a user, and accepts an interface from a user operation about the sampling interval.
Fig. 5 is a diagram of an example of a method of linking the first simulator and the second simulator through the simulator linkage device in the simulation system of Fig. 2.
Fig. 6 is a diagram of an example, which is different from that shown in Fig. 5, of a method of linking the first simulator and the second simulator through the simulator linkage device in the simulation system of Fig. 2.
Fig. 7 is a diagram of an example of an image displayed by the second simulator in the simulation system of Fig. 2.
Fig. 8 is a diagram of an example of an image, which is different from that shown in Fig. 7, displayed by the second simulator in the simulation system of Fig. 2.
Fig. 9 is a diagram of an example of an image displayed by the first simulator in the simulation system of Fig. 2.
Fig. 10 is a diagram for describing a model-based design becoming possible by means of the simulation system of Fig. 2.

### DESCRIPTION OF THE EMBODIMENTS

### [Embodiment 1]

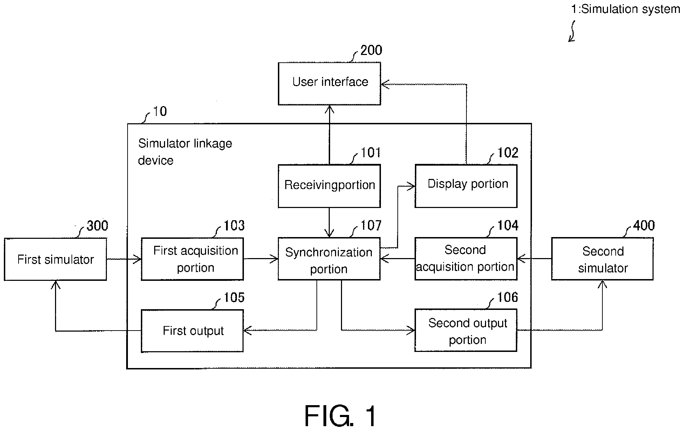

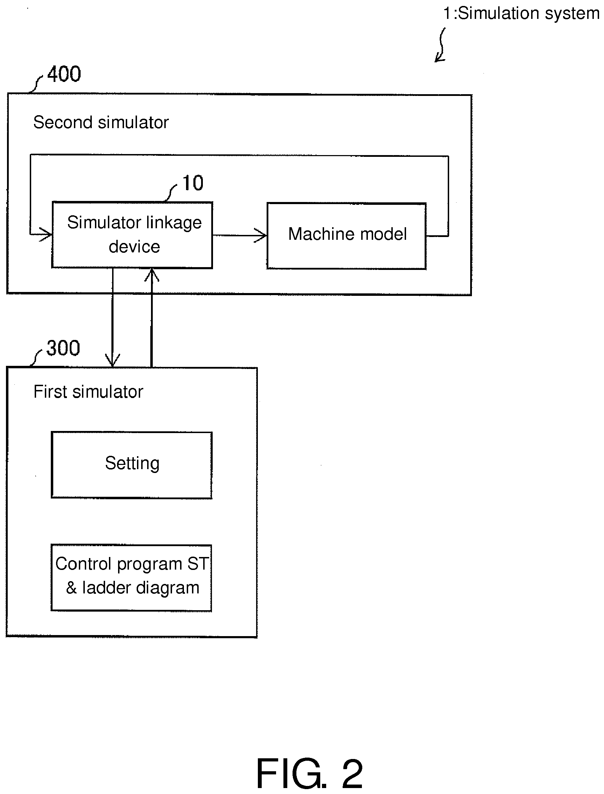

In the following, Embodiment 1 of the present invention is described in detail based on Fig. 1 to Fig. 10. Identical symbols are marked for identical or equivalent parts in the figures, and the descriptions thereof are not repeated. To facilitate understanding of a simulator linkage device 10 according to a solution of the present invention, at first, a profile of a simulation system 1 including the simulator linkage device 10 is described using Fig. 2.

### (control system)

Fig. 2 is a diagram indicating a profile of a simulation system 1 including the simulator linkage device 10. The simulation system 1 includes: (1) a first simulator 300, which is a simulator for an upper controller such as a programmable controller (Programmable Logic Controller, PLC); (2) a second simulator 400, which is a simulator for a controlled device (a lower controller such as a servo driver and a mechanical element driven by the lower controller) controlled by the upper controller; and (3) a simulator linkage device 10 that links the first simulator 300 and the second simulator 400. The simulator linkage device 10 controls simulation execution of the first simulator 300 and the second simulator 400 (especially data exchange and simulation time between the first simulator 300 and the second simulator 400).

In addition, in the simulation system 1 illustrated in Fig. 2, the simulator linkage device 10 is formed as a device integrated with the second simulator 400. However, the simulator linkage device 10 does not have to be formed as a device integrated with the second simulator 400. The simulator linkage device 10, for example, may also be formed as a device integrated with the first simulator 300, and may also be formed as a device independent of both the first simulator 300 and the second simulator 400, as long as the simulator linkage device 10 can link the first simulator 300 and the second simulator 400, which, for example, may also be formed as a device integrated with a third device different from both the first simulator 300 and the second simulator 400.

### (Profile of the first simulator)

The simulator of the upper controller, that is, the first simulator 300, sends an instruction value (control signal) of drive control (e.g., "orbit following control" and "orbit control in a processing machine", etc.) executed by a simulation object for the second simulator 400, that is, a controlled device, to the second simulator 400 via the simulator linkage device 10.

Moreover, the first simulator 300, when executing simulator for the upper controller, sends an execution result, that is, a first execution result, to a simulator for a controlled device controlled by the upper controller, that is, the second simulator 400.

Then, the first simulator 300 receives output from the second simulator 400, that is, control quantity (second execution result), as feedback information. The first simulator 300 uses the second execution result (the control quantity output from the second simulator 400) received from the second simulator 400 as feedback information to execute simulation for the upper controller.

In addition, in the simulation system 1, the first simulator 300 may be a simulator of an upper controller and may also be a device that provides a development environment of the upper controller. That is, the first simulator 300 may also be a device that provides an Integrated Development Environment (IDE), that is, in addition to configuration (structural setting), programming, debugging, maintenance, monitoring functions of the upper controller such as a PLC, it also supports Three Dimensional (3D) motion simulation. The first simulator 300, for example, can program the upper controller by using an Instruction List (IL) language, a Ladder Diagram (LD) language, a Sequential Function Chart (SFC) language, a Function Block Diagram (FBD) language, a Structured Text (ST) language and the like. The first simulator 300 prepares multiple languages capable of programming the upper controller, and thus the user can select a skill and experienced language, and can be distinguished corresponding to uses. The first simulator 300 may use the LD language and the ST language, and thus can deal with all the uses.

In addition, the first simulator 300 can automatically generate a program (e.g., ST language) for an upper controller such as a PLC according to a control model in the second simulator 400. That is, the simulator linkage device 10 can import the model in the second simulator 400, as a Function Block (FB), into the first simulator 300, to make other user programs to be utilized similarly.

### (Profile of the second simulator)

The second simulator 400 is a simulator for a controlled device (a lower controller such as a servo driver and a mechanical element driven by the lower controller) controlled by the upper controller, which, for example, including a machine model.

The second simulator 400 receives an instruction value (control signal) from the simulator of the upper controller, that is, the first simulator 300. The second simulator 400, based on the received instruction value, executes simulation for the controlled device (a lower controller such as a servo driver and a mechanical element driven by the lower controller) controlled by the upper controller.

Moreover, the second simulator 400, when executing simulation for the controlled device, sends an execution result, that is, the second execution result, as feedback information, to the simulator for the upper controller, that is, the first simulator 300.

Then, the second simulator 400 receives, from the first simulator 300, the result obtained by executing simulation for the upper controller by the first simulator 300, that is, a first execution result. The second simulator 400 uses the received first execution result to execute simulation for the controlled device.

In addition, in the simulation system 1, the second simulator 400 may be a simulator of the controlled device, and may also be a device that provides a development environment of the controlled device (a lower controller such as a servo driver). That is, the second simulator 400 may also provide a graph editor for making a model as a block diagram, and can simulate dynamic motion of a defined model and display a simulation execution result. The second simulator 400, for example, may also be a control Computer Aided Design (CAD) such as MATLAB/Simulink (registered trademark). In the simulation system 1, when the simulator linkage device 10 is formed as a device integrated with the second simulator 400, the simulator linkage device 10, for example, may also be formed as a control CAD that can be added on MATLAB/Simulink (registered trademark), that is, the second simulator 400.

### (Profile of the control system)

For the overall program and design verification of the upper controller and a controlled device (a lower controller such as a servo driver, etc.) controlled by the upper controller, it is expected to inhibit additional assignment and advance execution before real machine verification.

Moreover, the past development environment (development device) of the upper controller such as a PLC cannot obtain a feedback value from the controlled device controlled by the upper controller. Therefore, the user of the development environment of the upper controller has to make a program for debugging in the development environment, to facilitate motion of the controlled device.

Herein, in the model-based design, the model of the controlled device controlled by the upper controller such as a PLC is made by using a software design procedure through a control CAD such as MATLAB/Simulink (registered trademark).

In the simulation system 1, the simulator linkage device 10 can utilize the model of the controlled device made with the second simulator 400 in the software design procedure, and the second simulator 400 is a simulator for the controlled device of a lower controller such as a servo driver and is a development environment of the lower controller. That is, in the simulation system 1, the simulator linkage device 10 can make the first simulator 300 utilize the model of the controlled device made with the second simulator 400, and the first simulator 300 is a simulator of an upper controller, and a development environment of the upper controller.

In the simulation system 1, the simulator linkage device 10 makes the first simulator 300 and the second simulator 400 exchange necessary data while obtaining their simulation time, to cause them to execute simulation. Especially, in the simulation system 1, the simulator linkage device 10 makes the first simulator 300 and the second simulator 400 execute simulation synchronously respectively at a time interval set by a user.

Therefore, in the simulation system 1, for example, programs and set verification such as "make an alarm and stop in the case of overspeeding" and "whether limit setting of an axis variable functions as assumed" difficult to generate in a real machine or generating dangerous motion in the real machine can be performed.

Moreover, in the simulation system 1, the simulator linkage device 10, as described below, can perform automatic testing using the second simulator 400, so as to reduce the overall program and designed verification working hours of the upper controller and the lower controller.

Then, the simulator linkage device 10, even if changing an execution speed of a program through one cycle execution of the program and breakpoint setting in the first simulator 300, also maintains synchronization with the simulation time of the second simulator 400. Therefore, the user, by using the simulator linkage device 10, can perform rigorous logic verification for the upper controller and the controlled device.

Moreover, the simulator linkage device 10, even if in a situation that simulation execution is temporarily stopped or step-performed in the second simulator 400, can also maintain synchronization with the simulation time of the first simulator 300.

### (about the model-based design)

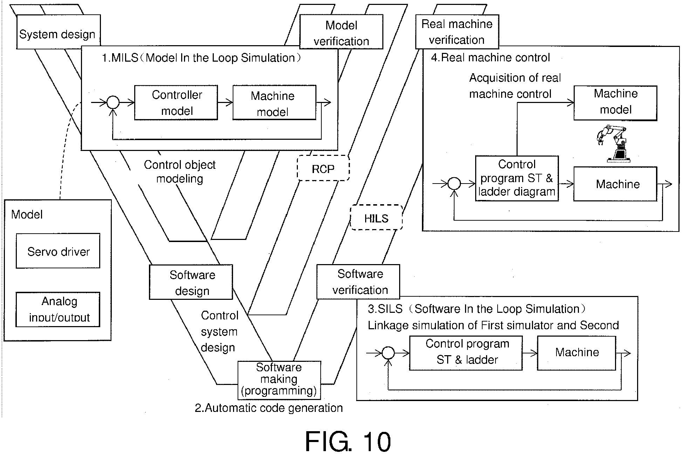

Fig. 10 is a diagram for describing a model-based design becoming possible through the simulation system 1. As shown in Fig. 10, in the model-based design, a system design phase, a software design phase, and a software making (programming) phase are advanced sequentially. Moreover, in the model-based design becoming possible through the simulation system 1, model verification, software verification and real machine verification can be performed in the system design phase, the software design phase, and the software making (programming) phase.

In a control object modelling procedure performed in a period from the system design phase to the software design phase, the user utilizes the second simulator 400 to model control objects such as a servo driver and/or analog input/output. The user, for a controller model and a machine model designed using the second simulator 400, can use at least one of the first simulator 300 and the second simulator 400 linked through the simulator linkage device 10 to perform model verification. In addition, in the following description, the control object modelling is abbreviated as "MILS (Model In the Loop Simulation)."

For MILS, as the simulator linkage device 10 links the first simulator 300 and the second simulator 400, a model of an I/O device in the second simulator 400 can be simulated based on setting of an I/O device set in the first simulator 300. Accordingly, confirmation and adjustment considering characteristics and control performance of the I/O device can be performed, and verification including setting of the I/O device can be performed.

In the software design phase, the user can use the first simulator 300 to design a control system (an upper controller such as a PLC). The user, for the control system designed using the first simulator 300, can perform model verification by using at least one of the first simulator 300 and the second simulator 400 linked through the simulator linkage device 10.

Then, in the software making (programming) phase, the user makes software by using the first simulator 300 and the second simulator 400 linked through the simulator linkage device 10. The user performs software verification on the made software, for example, performs software verification by using at least one of the first simulator 300 and the second simulator 400 linked through the simulator linkage device 10. In addition, in the following description, the software verification is abbreviated as "SILS (Software In the Loop Simulation)."

Moreover, the user can execute SILS by making the simulator linkage device 10 execute linkage simulation of the first simulator 300 and the second simulator 400. That is, the user, through the simulator linkage device 10, can perform verification in advance before the real machine verification, and can perform hand-coding program and overall program verification of a device including a display. Moreover, the user can perform rigorous logic verification by executing one cycle execution of the program and breakpoint setting, and then, can also easily perform repeated verification, automatic execution of verification, verification of rare cases and so on.

After the software verification, the user performs real machine verification. At this point, the user makes the second simulator 400 and a machine (the controlled device) to move through the upper controller (or the first simulator 300), which can thus make the second simulator 400 acquire real machine control data (data obtained during actual motion of the machine).

As the simulator linkage device 10 links the first simulator 300 and the second simulator 400, the user can use the second simulator 400 to monitor data used in at least one of the upper controller such as a PLC controlling the real machine and the first simulator 300. Moreover, the user can also write, from the second simulator 400, a control parameter (adjustment parameter) used in at least one of the upper controller and the first simulator 300. That is, the user can, similarly to MILS and SILS, use the second simulator 400 to monitor real machine control, and can monitor the environment. The user can compare simulation with real machine control without adding time and effort, and can adjust, from the second simulator 400, the control parameter used in at least one of the upper controller and the first simulator 300, which can thus make the parameter between the model used in the second simulator 400 and the real machine consistent all the time.

By means of the model-based design becoming possible through the simulation system 1, for system design and software design, the working hours may be slightly increased due to model making and simulation execution, but for software making, the working hours may be significantly reduced through automatic code generation, and for software verification, the working hours may also be significantly reduced due to errors in the design phase. Details are described below.

In the past development process, the control design and verification is performed in a later stage, and thus the working hours tend to increase in the latter half stage of the development. Relatively, in the model-based design shown in Fig. 10, the control design and verification can be performed before real machine assembling.

Herein, as a development flow becoming possible through the simulation system 1, the following four types may be listed. That is, firstly, the following flow may be listed: MILS is performed at first, next software making (programming) is performed, then SILS is performed, and finally real machine control (real machine verification). This is a standard development flow of the model-based design as illustrated in Fig. 10.

Secondly, the following flow may be listed: MILS is performed at first, and after SILS, real machine control (real machine verification) is performed. When the controller model developed in the second simulator 400 is simple, the user sometimes may replace execution of automatic code generation to program through manual operations, and perform real machine control (real machine verification).

Thirdly, the following flow may be listed: MILS is performed at first, and after software making (programming), real machine control (real machine verification) is performed. When most of the control program is developed in the second simulator 400, the difference between MILS and SILS is small. Moreover, as the simulator linkage device 10 links the first simulator 300 and the second simulator 400, SILS is not required.

Fourthly, the following flow may be listed: after SILS is performed at first, real machine control (real machine verification) is performed. The second simulator 400 is only used for controlling development and simulation of an object model, when all of the control program is developed in the first simulator 300, the development may also start from SILS as the simulator linkage device 10 links the first simulator 300 and the second simulator 400.

### (Effect produced by the simulation)

For example, in temperature control, as an example of a factor of difficult control, non-linear, characteristic variation, thermal disturbance, residence time and other characteristics arising out of the control object may be listed. Moreover, a situation of great external disturbance or continuation may also be listed as an example of a factor of difficult control. Then, due to slow response, a situation that tuning from time limitation is impossible may also be listed as an example of a factor of difficult control.

Through simulation, for characteristics arising out of the control object, a suitable control algorithm can be developed in a short period. Moreover, for the situation of great external disturbance or continuation, a suitable control algorithm may also be developed through simulation in a short period. Then, even if in the situation that tuning from time limitation is impossible due to low response, an optimal control parameter can be found through simulation in a short period.

### (Simulator linkage device)

The simulator linkage device 10 includes: an receiving portion 101 that accepts a sampling interval from a user, the sampling interval being an interval at which simulation is executed periodically; a first acquisition portion 103 that acquires a first execution result from a first simulator 300, the first simulator 300 being a simulator for a controller (e.g., PLC), and the first execution result being a simulation execution result of an amount of a sampling interval of the first simulator 300; a second acquisition portion 104 that acquires a second execution result from a second simulator 400, the second simulator 400 being a simulator for a controlled device (e.g., a lower controller such as a servo driver and a mechanical element driven by the lower controller) controlled by the controller, and the second execution result being a simulation execution result of an amount of a sampling interval of the second simulator 400; and a synchronization portion 107 that outputs the first execution result acquired by the first acquisition portion 103 to the second simulator 400, and outputs the second execution result acquired by the second acquisition portion 104 to the first simulator 300, making the first simulator 300 and the second simulator 400 execute simulation periodically with the sampling interval respectively.

According to the structure, the synchronization portion 107 makes the simulator for the controller, that is, the first simulator 300 and the simulator for a controlled device controlled by the controller, that is, the second simulator 400, execute simulation periodically at the sampling interval accepted from the user by the receiving portion 101 respectively.

Therefore, the simulator linkage device 10 produces the following effect: the first simulator 300 and the second simulator 400 are enabled to execute simulation synchronously and periodically at the sampling interval accepted from the user by the receiving portion 101 respectively.

For example, the user sets a long time interval as the sampling interval; accordingly, the synchronization portion 107 outputs the first execution result acquired by the first acquisition portion 103 to the second simulator 400 at the sampling interval which is the long time interval, and outputs the second execution result acquired by the second acquisition portion 104 to the first simulator 300 at the sampling interval which is the long time interval. At this point, the synchronization portion 107 can, before the first simulator 300 and the second simulator 400 complete simulation, inhibit the number of sending and receiving of the simulation execution results between the first simulator 300 and the second simulator 400 as a result, which can shorten the execution time of the whole simulation.

Moreover, for example, the user sets a short time interval as the sampling interval; accordingly, the synchronization portion 107 outputs the first execution result acquired by the first acquisition portion 103 to the second simulator 400 at the sampling interval which is the short time interval, and outputs the second execution result acquired by the second acquisition portion 104 to the first simulator 300 at the sampling interval which is the short time interval. At this point, the synchronization portion 107 notifies the second simulator 400 and the first simulator 300 about the result of simulation executed by the first simulator 300 and the second simulator 400 at the short time interval respectively each time. Therefore, compared with a situation of the longer sampling interval, simulation precision of the simulation execution result executed by the first simulator 300 and the second simulator 400 can be improved.

Therefore, the simulator linkage device 10 produces the following effect: the user can arbitrarily choose to attach importance to which one of the execution time of the simulation and the simulation precision of the simulation to execute the simulation.

The simulator linkage device 10 is formed as a device integrated with the second simulator 400.

According to the structure, the following effect is produced: the simulator linkage device 10 formed as a device integrated with the second simulator 400 enables the first simulator 300 to synchronously and periodically execute simulation with the simulation of the second simulator 400 at the sampling interval accepted by the receiving portion 101 from the user.

### (Details of the simulator linkage device)

For the simulator linkage device 10 whose profile is described above, details thereof are described in the following with Fig. 1.

Fig. 1 is a structural block diagram of main parts of a simulator linkage device 10 according to Embodiment 1 of the present invention. As shown in Fig. 1, the simulator linkage device 10 has an receiving portion 101, a display portion 102, a first acquisition portion 103, a second acquisition portion 104, a first output portion 105, a second output portion 106 and a synchronization portion 107.

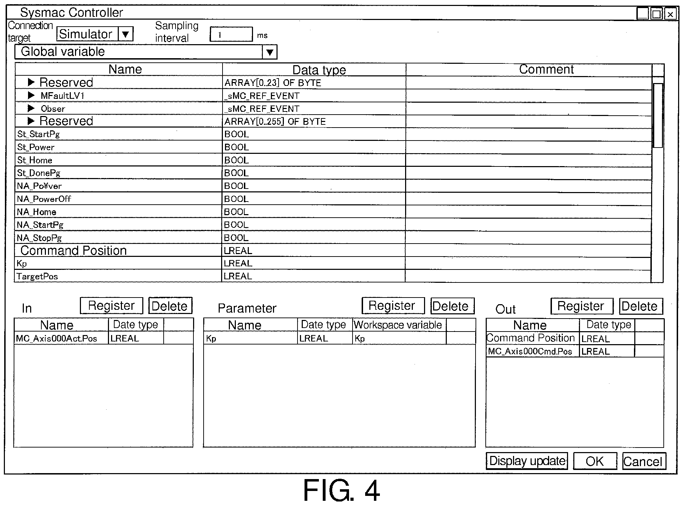

The receiving portion 101 accepts a user operation at a specified sampling interval, the sampling interval being an interval at which simulation is executed periodically by the first simulator 300 and the second simulator 400 respectively. Detailed contents will be described later with Fig. 4, the receiving portion 101 accepts, from the user, a sampling interval of each variable used when the first simulator 300 or the second simulator 400 executes simulation.

The display portion 102 displays an image for the user to confirm and set a sampling interval, for example, on a user interface 200. An example of the "image for the user to confirm and set a sampling interval" displayed by the display portion 102 is a sampling interval set image illustrated in Fig. 4. The display portion 102 uses a control cycle of an upper controller (e.g., PLC) simulated by the first simulator 300 as an initial set value of a sampling interval that can be set by the user and displays it on the sampling interval set image. Moreover, detailed contents are described later with Fig. 4, the display portion 102 displays, for each variable used when the first simulator 300 or the second simulator 400 executes simulation, the sampling interval that can be set by the user on the sampling interval set image.

The first acquisition portion 103 acquires a first execution result from the first simulator 300, the first execution result being a simulation execution result of an amount of a sampling interval of the first simulator 300. The first acquisition portion 103 sends the first execution result acquired from the first simulator 300 to the synchronization portion 107.

The second acquisition portion 104 acquires a second execution result from the second simulator 400, the second execution result being a simulation execution result of an amount of a sampling interval of the second simulator 400. The second acquisition portion 104 sends the second execution result acquired from the second simulator 400 to the synchronization portion 107.

The first output portion 105 outputs the second execution result acquired by the second acquisition portion 104 from the second simulator 400 to the first simulator 300 at a time indicated by the synchronization portion 107. The first output portion 105, for example, acquires the second execution result from the synchronization portion 107, and outputs the acquired second execution result to the first simulator 300 at a time indicated by the synchronization portion 107.

The second output portion 106 outputs the first execution result acquired by the first acquisition portion 103 from the first simulator 300 to the second simulator 400 at a time indicated by the synchronization portion 107. The second output portion 106, for example, acquires the first execution result from the synchronization portion 107, and outputs the acquired first execution result to the second simulator 400 at a time indicated by the synchronization portion 107.

The synchronization portion 107 executes simulation periodically by the first simulator 300 and the second simulator 400 respectively at the sampling interval accepted by the receiving portion 101 from the user. The synchronization portion 107, after the first simulator 300 completes simulation of the amount of the sampling interval, makes the first output portion 105 output the simulation execution result of the amount of the sampling interval of the second simulator 400, that is, the second execution result, to the first simulator 300. Moreover, the synchronization portion 107 instructs the first simulator 300 to use the second execution result to execute simulation of the amount of the sampling interval.

Moreover, the synchronization portion 107, after the second simulator 400 completes simulation of the amount of the sampling interval, makes the second output portion 106 output the simulation execution result of the amount of the sampling interval of the first simulator 300, that is, the first execution result, to the second simulator 400. Besides, the synchronization portion 107 instructs the second simulator 400 to use the first execution result to execute simulation of the amount of the sampling interval.

As shown in Fig. 1, a user interface 200 may also be connected on the simulator linkage device 10. The user interface 200, for example, is a Human Machine Interface (HMI). The HMI is a member for human and machine to exchange information, and specifically, is a member that the human operates a machine (gives an instruction to the machine) or the machine notifies the human about a current state/result. The HMI, as a member that the human gives an instruction to the machine, includes a switch, a button, a handle, a dial, a pedal, a remote controller, a microphone, a keyboard, a mouse and the like, and as a member that the machine notifies the human about a current state/result, includes an LCD screen, a meter, a lamp, a speaker and so on.

### (Details of processing executed in the simulation system 1)

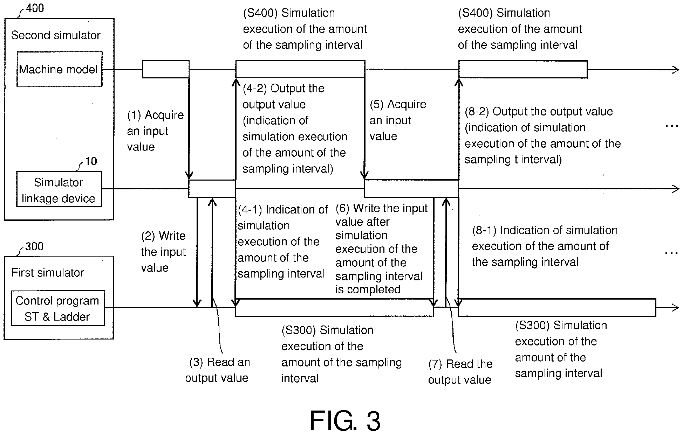

Fig. 3 is a flowchart of processing flows of a first simulator 300, a second simulator 400 and a simulator linkage device 10 in the simulation system 1. In addition, in the following description, suppose that the simulator linkage device 10, in the "step (0)" not shown, accepts, from a user, an interval at which the first simulator 300 and the second simulator 400 periodically execute simulation respectively, that is, "sampling interval".

The second acquisition portion 104 of the simulator linkage device 10 acquires, from the second simulator 400 (especially a machine model thereof), a simulation execution result of the second simulator 400, that is, an input value (second execution result) (step (1): acquire an input value).

The first output portion 105 of the simulator linkage device 10 sends the input value (second execution result) acquired from the second simulator 400 to the first simulator 300 (step (2): write the input value).

The first acquisition portion 103 of the simulator linkage device 10 acquires an output value (first execution result) from the first simulator 300 (step (3): read an output value).

The synchronization portion 107 of the simulator linkage device 10 instructs the first simulator 300 to execute simulation of the amount of the sampling interval (step (4-1)). The first simulator 300 follows the instruction from the simulator linkage device 10 (especially the synchronization portion 107) to execute simulation of the amount of the sampling interval (step S300).

Moreover, the synchronization portion 107 of the simulator linkage device 10 makes the second output portion 106 output (send) the output value (first execution result) to the second simulator 400, and uses the output value to instruct the second simulator 400 to execute simulation of the amount of the sampling interval (step (4-2)). The second simulator 400 follows the instruction from the simulator linkage device 10 (the synchronization portion 107) to execute simulation of the amount of the sampling interval (step S400). Besides, step (4-1) and step (4-2) are collectively referred to as "step (4)."

The second acquisition portion 104 of the simulator linkage device 10 acquires, from the second simulator 400, the simulation execution result executed in step S400 by the second simulator 400, that is, the input value (second execution result) (step (5): acquire the input value).

After the first simulator 300, based on the instruction from the synchronization portion 107 of the simulator linkage device 10, executes simulation of the amount of the sampling interval (after simulation execution of the amount of the sampling interval is completed), the first output portion 105 of the simulator linkage device 10 sends the input value (second execution result) acquired from the second simulator 400 in step (5) to the first simulator 300 (step (6): write the input value).

The first acquisition portion 103 of the simulator linkage device 10 acquires, from the first simulator 300, the simulation execution result executed in step S300 by the first simulator 300, that is, the output value (first execution result) (step (7): read the output value).

The synchronization portion 107 of the simulator linkage device 10 instructs the first simulator 300 to use the second execution result acquired in step (6) by the first simulator 300 to execute simulation of the amount of the sampling interval (step (8-1)). The first simulator 300 follows the "instruction in step (8-1)" from the simulator linkage device 10 (especially the synchronization portion 107) to execute simulation of the amount of the sampling interval (step S300).

Moreover, the synchronization portion 107 of the simulator linkage device 10 makes the second output portion 106 output (send) the first execution result acquired from the first simulator 300 from step (7) to the second simulator 400. Moreover, the synchronization portion 107 instructs the second simulator 400 to use the first execution result acquired by the first acquisition portion 103 from the first simulator 300 in step (7) to the second simulator 400. Also, the synchronization portion 107 instructs the second simulator 400 to use the first execution result acquired by the first acquisition portion 103 from the first simulator 300 in step (7) to execute simulation of the amount of the sampling interval (step (8-2)). The second simulator 400 follows the "instruction in step (8-2)" from the simulator linkage device 10 (the synchronization portion 107) to execute simulation of the amount of the sampling interval (step S400). In addition, step (8-1) and step (8-2) are collectively referred to as "step (8)."

Processing executed by the simulator linkage device 10 (control method of the simulator linkage device 10) described with Fig. 3 may be sorted as follows. That is, the processing executed by the simulator linkage device 10 is a control method of a simulator linkage device that links simulation executed by multiple simulators respectively, the control method including: an accepting step (step (0)) of accepting a sampling interval from a user, the sampling interval being an interval at which simulation is executed periodically; a first acquisition step (step (3) and step (7)) of acquiring a first execution result from a first simulator 300, the first simulator 300 being a simulator for a controller (e.g., PLC), and the first execution result being a simulation execution result of the amount of the sampling interval of the first simulator 300; a second acquisition step (step (1) and step (5)) of acquiring a second execution result from a second simulator 400, the second simulator 400 being a simulator for a controlled device (a lower controller such as a servo controller and a mechanical element driven by the lower controller) controlled by the controller, and the second execution result being a simulation execution result of the amount of the sampling interval of the second simulator 400; and a synchronization step (step (4) and step (8)) of outputting the first execution result acquired by the first acquisition step to the second simulator 400, and outputting the second execution result acquired by the second acquisition step to the first simulator 300, making the first simulator 300 and the second simulator 400 execute simulation periodically with the sampling interval respectively.

According to the method, the synchronization step makes the simulator for the controller, that is, the first simulator 300 and the simulator for a controlled device controlled by the controller, that is, the second simulator 400, execute simulation periodically at the sampling interval accepted from the user in the accepting step respectively.

Therefore, the control method produces the following effect: the first simulator 300 and the second simulator 400 are enabled to execute simulation synchronously and periodically at the sampling interval accepted from the user in the accepting step respectively.

For example, the user sets a long time interval as the sampling interval; accordingly, the synchronization step outputs the first execution result acquired in the first acquisition step to the second simulator 400 at the sampling interval which is the long time interval, and outputs the second execution result acquired in the second acquisition step to the first simulator 300 at the sampling interval which is the long time interval. At this point, the synchronization step can, before the first simulator 300 and the second simulator 400 complete simulation, inhibit the number of sending and receiving of the simulation execution results between the first simulator 300 and the second simulator 400 as a result, which can shorten the execution time of the whole simulation.

Moreover, for example, the user sets a short time interval as the sampling interval; accordingly, the synchronization step outputs the first execution result acquired in the first acquisition step to the second simulator 400 at the sampling interval which is the short time interval, and outputs the second execution result acquired in the second acquisition step to the first simulator 300 at the sampling interval which is the short time interval. At this point, the synchronization step notifies the second simulator 400 and the first simulator 300 about the result of simulation executed by the first simulator 300 and the second simulator 400 at the short time interval respectively each time. Therefore, compared with a situation of the longer sampling interval, simulation precision of the simulation execution result executed by the first simulator 300 and the second simulator 400 can be improved.

Therefore, the control method produces the following effect: the user can arbitrarily choose to attach importance to which one of the execution time of the simulation and the simulation precision of the simulation to execute the simulation.

### (About setting of the sampling interval by the user)

Fig. 4 is a diagram of an example in which the simulator linkage device 10 displays an interval at which simulation is executed periodically, that is, a sampling interval, to a user, and accepts an interface from a user operation about the sampling interval.

The sampling interval set image illustrated in Fig. 4, for example, is displayed on the user interface 200 by the display portion 102. Moreover, the user operation for the sampling interval set image in Fig. 4 is processed (accepted) by the receiving portion 101. For example, the simulator linkage device 10 makes the first simulator 300 and the second simulator 400 periodically execute simulation respectively at a sampling interval set by the user on the sampling interval set image in Fig. 4.

In the simulation system 1, generally, a simulation object of the first simulator 300, that is, a control cycle of the upper controller, is set by the user as a sampling interval. That is, the display portion 102 displays a control cycle of the upper controller (e.g., PLC) on the sampling interval set image illustrated in Fig. 4, as an initial set value of the interval at which the first simulator 300 and the second simulator 400 periodically execute simulation respectively, that is, the sampling interval.

According to the structure, the display portion 102 displays the control cycle of the upper controller as an initial set value of the sampling interval.

Therefore, the simulator linkage device 10 produces the following effect: the simulator for the upper controller, that is, the first simulator 300, is enabled to execute simulation with the control cycle of the upper controller, and the simulator for the controlled device controlled by the upper controller, that is, the second simulator 400, is also enabled to execute simulation synchronously with simulation of the first simulator 300.

However, the user can also set, on the sampling interval set image illustrated in Fig. 4, a value different from the control cycle of the upper controller as the sampling interval. For example, in the simulator linkage device 10, the sampling interval may be set to a time longer than the control cycle of the upper controller.

According to the structure, the synchronization portion 107 outputs the first execution result acquired from the first acquisition portion 103 to the second simulator 400 at the sampling interval, the sampling interval being a time longer than the control cycle of the upper controller, and outputs the second execution result acquired by the second acquisition portion 104 to the first simulator 300 at the sampling interval accepted by the receiving portion 101.

Therefore, the synchronization portion 107 produces the following effect: before the first simulator 300 and the second simulator 400 complete simulation, the number of sending and receiving of the simulation execution results between the first simulator 300 and the second simulator 400 can be inhibited. That is, the simulator linkage device 10 produces the following effect: the time during which the first simulator 300 and the second simulator 400 complete simulation can be shortened.

In the simulator linkage device 10, the user, by setting the sampling interval to be longer, the number of times of data exchange between the first simulator 300 and the second simulator 400 can be reduced, thus shortening the execution time of the simulation.

As illustrated in Fig. 4, the user can set, on the sampling interval set image, the sampling interval for each variable used when the first simulator 300 or the second simulator 400 executes simulation. That is, in the simulator linkage device 10, the receiving portion 101 accepts, from the user, the sampling interval for each variable used when the first simulator 300 or the second simulator 400 executes simulation.

According to the structure, the synchronization portion 107 makes, for the sampling interval set for each variable used when the first simulator 300 or the second simulator 400 executes simulation, the variable sent and received between the first simulator 300 and the second simulator 400.

Therefore, the simulator linkage device 10 produces the following effect: a variable can be sent and received between the first simulator 300 and the second simulator 400 by taking each variable used when the first simulator 300 or the second simulator 400 executes simulation as an optimal time interval, which can thus shorten the time during which the first simulator 300 and the second simulator 400 complete simulation.

Herein, for example, when the upper controller executes multiple processing in parallel, the receiving portion 101 can accept sampling intervals from the user respectively for multiple simulation executed by the first simulator 300 corresponding to the multiple processing. Moreover, the synchronization portion 107 outputs respective simulation execution results of the multiple simulation to the second simulator 400 at the respective sampling intervals of the multiple simulation.

Therefore, the simulator linkage device 10 produces the following effect: by outputting respective simulation execution results of the multiple simulation executed by the first simulator 300 in parallel to the second simulator 400 at an interval optimal for each of the multiple simulation, the time during which the first simulator 300 and the second simulator 400 complete simulation can be shortened.

For example, when a multi-task function is used in the simulation object of the first simulator 300, that is, the upper controller, the simulator linkage device 10 performs data exchange corresponding to a task cycle of a referenced variable, and accordingly, the number of times of data exchange between the first simulator 300 and the second simulator 400 can also be reduced, thus shortening the execution time of the simulation.

The controller, for example, may also have the following three tasks, that is: a primary fixed-cycle task that uses "EtherCAT communication, motion control, I/O refresh and user program" as main processing contents; a fixed-cycle task that uses "I/O refresh and user program" as main processing contents; and an event task that uses "user program" as main processing contents. The controller first executes the primary fixed-cycle task, a precedence relationship between the fixed-cycle task and the event task may also be specified by the user, and then each task, for example, may also be assigned with 128 programs at most.

### (About data exchanged between simulators)

Signals (information) acquired by the simulator linkage device 10 from at least one of the first simulator 300 and the second simulator 400 include signals whose values (e.g., feedback values as simulation execution results) may change and signals whose values (e.g., Proportional Integral Derivative (PID) parameters, etc.) do not change due to execution of respective simulation in the first simulator 300 and the second simulator 400.

In the simulator linkage device 10, the signals (information) whose values do not change due to execution of simulation are, only at the initial time of the first data exchange, written from the first simulator 300 to the second simulator 400, or written from the second simulator 400 to the first simulator 300, to reduce the exchange amount of data.

That is, in the simulator linkage device 10, the synchronization portion 107, before the first simulator 300 executes simulation, outputs a variable to the first simulator 300 only once, the variable being a variable used by simulation in the first simulator 300 and a variable whose value does not change due to execution of the simulation in the first simulator 300.

According to the structure, the synchronization portion 107, before the second simulator 400 executes simulation, outputs a variable to the second simulator 400 only once, the variable being a variable used by simulation in the second simulator 400, and a variable whose value does not change due to execution of the simulation in the second simulator 400.

Therefore, the synchronization portion 107 produces the following effect: the amount of data sent and received between the first simulator 300 and the second simulator 400 can be inhibited. That is, the simulator linkage device 10 produces the following effect: the time during which the first simulator 300 and the second simulator 400 complete simulation can be shortened.

### (About a use example of the simulator linkage device)

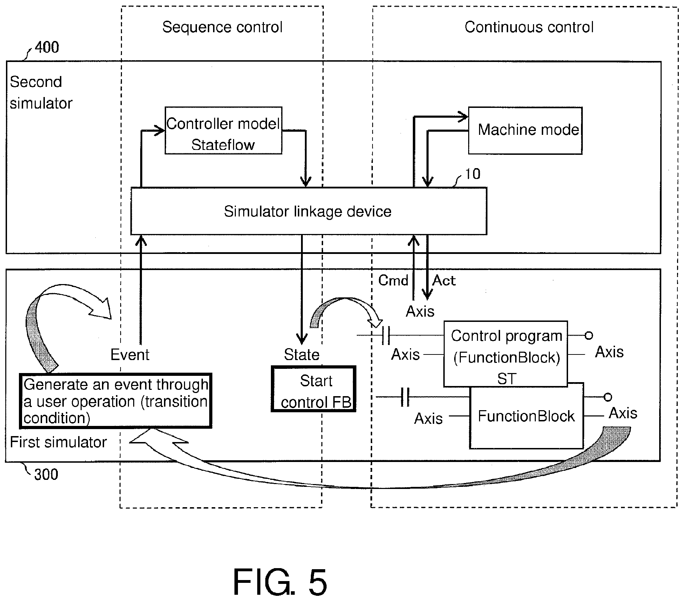

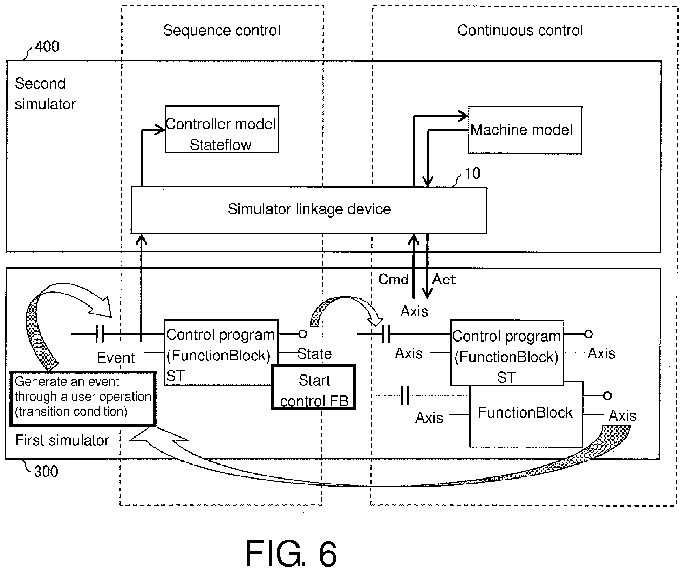

For the simulator linkage device 10 that has been described so far, a use method thereof is described in the following using a specific example with reference to Fig. 5 and Fig. 6.

Fig. 5 is a diagram of an example of a method of linking the first simulator 300 and the second simulator 400 through the simulator linkage device 10 in the simulation system 1.

As shown in Fig. 5, the simulator linkage device 10 can be used when a sequence-controlled controller model is designed. That is, the user first operates, for example, a user interface 200 as an HMI (or operating the first simulator 300), to make an event (i.e., a transition condition is met, to transit a state) generated in the first simulator 300.

The simulator linkage device 10 acquires a state transition result in the first simulator 300 as a first execution result (the simulation execution result in the first simulator 300). The simulator linkage device 10 sends the state transition result in the first simulator 300 to the second simulator 400, to make the second simulator 400 execute simulation using the state transition result in the first simulator 300.

In the example shown in Fig. 5, the simulator linkage device 10, for example, uses the sequence-controlled controller model (e.g., Stateflow (registered trademark)) to execute simulation using the state transition result in the first simulator 300.

The user can confirm a simulation result of the controller model in the second simulator 400 according to a state diagram, modify the controller model properly as required, and make the modified controller model re-execute simulation using the state transition result in the first simulator 300.

The simulator linkage device 10 acquires a simulation execution result of the controller model in the second simulator 400, as a second execution result (simulation execution result in the second simulator 400). The simulator linkage device 10 sends the simulation execution result of the controller model to the first simulator 300, making the first simulator 300 execute simulation using the simulation execution result of the controller model.

The first simulator 300 executes simulation using the simulation execution result of the controller model, for example, start a control program, use the simulation execution result of the controller model to perform a control program, and so on.

The simulator linkage device 10 acquires the simulation execution result of the first simulator 300, as the first execution result. The simulator linkage device 10 sends the simulation execution result acquired from the first simulator 300 to the second simulator 400, to make the second simulator 400 execute simulation.

In the example shown in Fig. 5, the simulator linkage device 10, for example, uses a continuously controlled machine model to execute simulation using the simulation execution result of the first simulator 300.

Fig. 5 indicates an example in which the second simulator 400 is not only configured with a machine model but also configured with a sequence-controlled controller model for simulation. In Fig. 5, in the first simulator 300, a control program for sequence control is not prepared. However, the simulator linkage device 10 exchanges data (e.g., Cmd and Act) between the first simulator 300 and the second simulator 400 without omissions. Accordingly, as shown in Fig. 5, the simulator linkage device 10 can be used in the design of the controller model for sequence control.

### (About another use example of the simulator linkage device)

Fig. 6 is a diagram of an example, which is different from that shown in Fig. 5, of a method of linking the first simulator 300 and the second simulator 400 through the simulator linkage device 10 in the simulation system 1. In the example illustrated in Fig. 6, different from the example illustrated in Fig. 5, in the first simulator 300, a control program for sequence control is prepared. As shown in Fig. 6, when the simulator linkage device 10 can be used in the design of the controller model for sequence control, the user can monitor the controller model (Stateflow) according to a state diagram, and thus visuality is increased.

As illustrated in Fig. 6, the simulator linkage device 10 links the first simulator 300 and the second simulator 400, accordingly, the first simulator 300 enables the controller model (Stateflow) in the second simulator 400 as a function block (FB) to be displayed in the first simulator 300. Through the simulator linkage device 10, the first simulator 300 and the second simulator 400 are linked to each other, which not only can share data but also can share model, program and so on. Therefore, the user, for example, as illustrated in Fig. 6, can confirm, in the first simulator 300, a model modelled in the second simulator 400, and utilize it in the first simulator 300. That is, the controller model (Stateflow) can be used as a FB through automatic code generation.

The user, similarly as shown in Fig. 5, first operates, for example, a user interface 200 as an HMI (or operating the first simulator 300), to generate an event in the first simulator 300 (that is, a transition condition is met, to transit the state).

The simulator linkage device 10 acquires a state transition result in the first simulator 300, as the first execution result (the simulation execution result in the first simulator 300). The simulator linkage device 10 sends the state transition result in the first simulator 300 to the second simulator 400, to make the second simulator 400 execute simulation using the state transition result in the first simulator 300.

In the example illustrated in Fig. 6, the simulator linkage device 10, for example, a controller model (Stateflow) for sequence control to execute simulation using the state transition result in the first simulator 300.

The user can confirm a simulation result of the controller model in the second simulator 400 according to a state diagram, and thus visuality is increased.

In addition, in the example shown in Fig. 6, different from the example shown in Fig. 5, the simulator linkage device 10 does not acquire the simulation execution result of the controller model.

In the example shown in Fig. 6, the simulator linkage device 10 sends "the state transition result in the first simulator 300 (user operation based state transition result in the first simulator 300)" acquired as the first execution result to the second simulator 400. The simulator linkage device 10 makes the second simulator 400 execute simulation using "the state transition result in the first simulator 300".

In the example shown in Fig. 6, the simulator linkage device 10, for example, is used in a continuously controlled machine model to execute simulation using "the state transition result in the first simulator 300 (user operation based state transition result in the first simulator 300)".

### (About other image examples confirmable by the user)

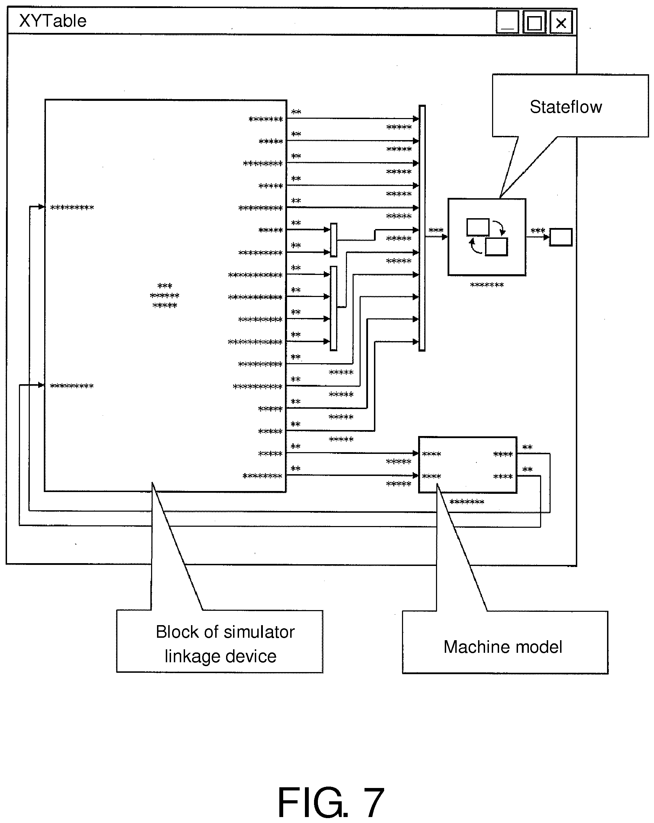

Image examples confirmable by the user other than the image examples described so far in the simulation system 1 are described with Fig. 7 to Fig. 9.

### (About an image example displayed by the second simulator)

Fig. 7 is a diagram of an example of an image displayed by the second simulator 400 in the simulation system 1. In the example shown in Fig. 7, a corresponding relationship between "a controller model (Stateflow) for sequence control and a machine model for continuous control" and "data exchange, simulation time and other items that the simulator linkage device 10 controls simulation of the second simulator 400" is displayed in an image.

The user, through the image shown in Fig. 7, for the overall structure of the controller model (Stateflow) and the machine model used respectively in the sequence control and the continuous control in the second simulator 400, can make confirmation while associating the control object of the simulator linkage device 10 (e.g., an item linked between the first simulator 300 and the second simulator 400 by the simulator linkage device 10). That is, the user, through the image shown in Fig. 7, for the overall structure of a lower controller such as a servo driver and a mechanical element driven by the lower controller, can make confirmation while associating the control object of the simulator linkage device 10 (e.g., associating a simulation item of the upper controller).

Moreover, the user, through the image shown in Fig. 7, can confirm flowing of data between the controller model (Stateflow) for sequence control and the machine model for continuous control in the second simulator 400. Then, for the flowing of data between the first simulator 300 and the second simulator 400 linked through the simulator linkage device 10, confirmation may also be made. That is, the user, through the image shown in Fig. 7, can confirm flowing of data between the first simulator 300 (the model of the upper controller) and the second simulator 400 (the controller model (Stateflow) and the machine model) linked through the simulator linkage device 10.

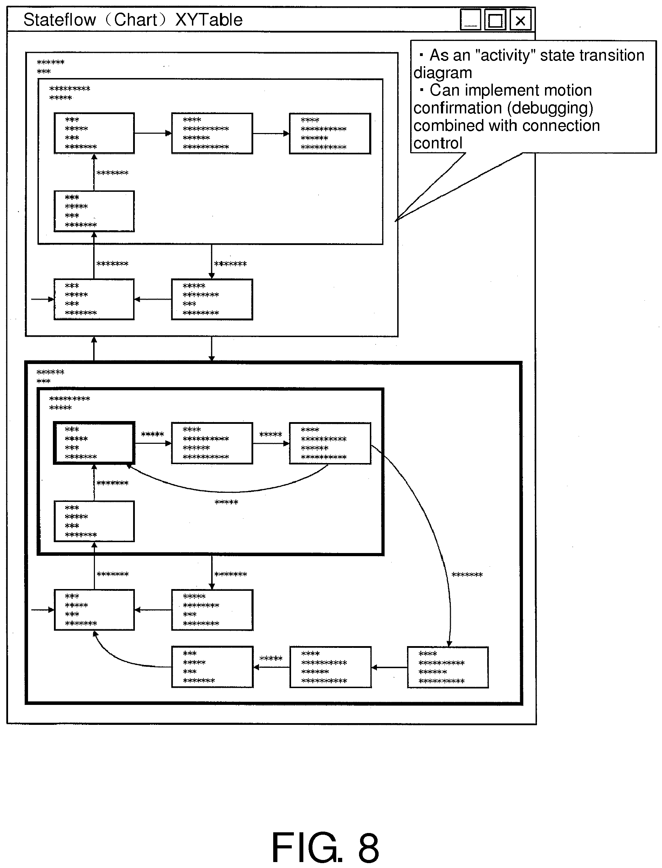

In addition, in the image shown in Fig. 7, by selecting components in the overall structure of the controller model (Stateflow) and the machine model by the user, an image where details about the components are confirmable may also be displayed. For example, in the image shown in Fig. 7, by selecting "the controller model (Stateflow)" through double-click by the user, an image (e.g., the image illustrated in Fig. 8) indicating details of the selected "controller model (Stateflow)" may also be displayed.

In addition, the second simulator 400 does not need to display the image example shown in Fig. 7, and the display portion 102 of the simulator linkage device 10 may also be displayed on the user interface 200.

Fig. 8 is a diagram of an example of an image, which is different from that shown in Fig. 7, displayed by the second simulator 400 in the simulation system 1. Specifically, an example of a state transition diagram of a controller model for sequence control is indicated. The image illustrated in Fig. 8, for example, may also be displayed by selecting the "controller model (Stateflow)" through double-click by the user through the image shown in Fig. 7.

In the image illustrated in Fig. 8, details of the controller model (Stateflow) indicating the profile in the overall structure illustrated in Fig. 7 are displayed. That is, in the image illustrated in Fig. 8, details of elements forming the controller model (Stateflow), functions, processing flows and the like are displayed.

Then, in the image illustrated in Fig. 8, display of the controller model (Stateflow) corresponding to processing, functions and the like of simulation execution may also be emphasized. For example, parts framed with thick lines in Fig. 8 may also indicate elements, functions, and processing of simulation execution.

The state transition diagram illustrated in Fig. 8 is used as an activity state transition diagram, and for the controller model, motion confirmation (debugging) combined with continuous control can be made. In addition, the second simulator 400 does not need to display the image example shown in Fig. 8, and the display portion 102 of the simulator linkage device 10 may also be displayed on the user interface 200.

### (About another image example displayed by the first simulator)

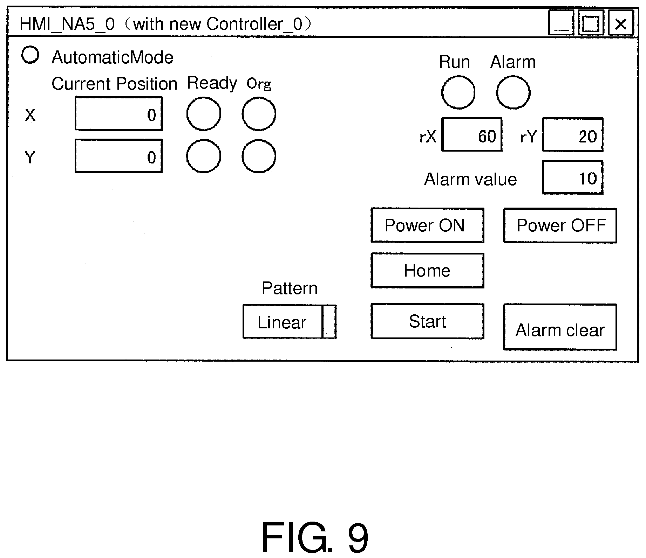

Fig. 9 is a diagram of an example of an image displayed by the first simulator 300 in the simulation system 1. Fig. 9 is an example of an image of "generating an event (i.e., a transition condition is met, to transit a state) in the first simulator 300". The user, for example, may operate the image of Fig. 9 displayed on the user interface 200, to generate an event in the first simulator 300.

That is, the user can use the image illustrated in Fig. 9 for servo ON/OFF (Power ON/Power OFF, in the case of servo ON, the servo driver electrifies a servo motor, and begins control), Home position reset (Home), operation start, alarm clear and other instructions. Moreover, the user can use the image illustrated in Fig. 9 to confirm the current state (current position) and the like.

In addition, the first simulator 300 does not need to display the image example illustrated in Fig. 9, and the display portion 102 of the simulator linkage device 10 may also be displayed on the user interface 200.

### (Implementation example by means of software)

A control block (especially the receiving portion 101, the display portion 102, the first acquisition portion 103, the second acquisition portion 104, the first output portion 105, the second output portion 106, and the synchronization portion 107) of the simulator linkage device 10 can be implemented through a logic circuit (hardware) on an integrated circuit (IC chip), and may also be implemented through software by using a Central Processing Unit (CPU).

In the latter case, the simulator linkage device 10 has a CPU executing a command of software, that is, program, that implements various functions, a Read Only Memory (ROM) computer-readable and recording the program and various data or storage device (referred to as "recording medium"), a Random Access Memory (RAM) developing the program and so on. Moreover, by reading and executing the program from the recording medium through a computer (or CPU), the objective of the present invention is achieved. As the recording medium, "a non-temporary tangible medium" can be used, for example, a tape, a disk, a card, a semiconductor memory, a programmable logic circuit and the like can be used. Moreover, the program may also be provided for the computer via any transmission medium (communication network or broadcast wave, etc.) that can transmit the program. In addition, the present invention may also be implemented in the form of data signals embedded into carriers which instantiate the program through electronic transmission.

The present invention is not limited to the implementations, various modifications may be made without the scope of the claims, and implementations obtained by properly combining technical parts disclosed in different implementations respectively may also be included in the technical scope of the present invention.

## Claims

1. A simulator linkage device (10), comprising:
an receiving portion (101) that accepts a sampling interval from a user, the sampling interval being an interval at which simulation is executed periodically;
a first acquisition portion (103) that acquires a first execution result from a first simulator (300), the first simulator (300) being a simulator for a controller, and the first execution result being a simulation execution result of an amount of a sampling interval of the first simulator (300);
a second acquisition portion (104) that acquires a second execution result from a second simulator (400), the second simulator (400) being a simulator for a controlled device controlled by the controller, and the second execution result being a simulation execution result of an amount of a sampling interval of the second simulator (400); and
a synchronization portion (107) that outputs the first execution result acquired by the first acquisition portion (103) to the second simulator (400), and outputs the second execution result acquired by the second acquisition portion (104) to the first simulator (300), making the first simulator (300) and the second simulator (400) execute simulation periodically with the sampling interval respectively.

2. The simulator linkage device (10) according to claim 1, further comprising:
a display portion (102) that displays a control cycle of the controller as an initial set value of the sampling interval.

3. The simulator linkage device (10) according to claim 1 or 2, wherein
the sampling interval may be set to a time longer than the control cycle of the controller.

4. The simulator linkage device (10) according to any of claims 1 to 3, wherein
the synchronization portion (7), before the first simulator (300) executes simulation, outputs a variable to the first simulator (300) only once, the variable is a variable used by simulation in the first simulator (300), and a variable whose value does not change due to execution of the simulation in the first simulator (300).

5. The simulator linkage device (10) according to any of claims 1 to 4, wherein
the receiving portion (101) accepts, from the user, a sampling interval of each variable used when the first simulator (300) or the second simulator (400) executes simulation.

6. The simulator linkage device (10) according to any of claims 1 to 5, wherein
the simulator linkage device (10) is formed as a device integrated with the second simulator (400).

7. A control method of a simulator linkage device (10) that links simulation executed by multiple simulators respectively, wherein the control method comprises:
an accepting step of accepting a sampling interval from a user, the sampling interval being an interval at which simulation is executed periodically;
a first acquisition step ((3), (7)) of acquiring a first execution result from a first simulator (300), the first simulator (300) being a simulator for a controller, and the first execution result being a simulation execution result of an amount of a sampling interval of the first simulator (300);
a second acquisition step ((1), (5)) of acquiring a second execution result from a second simulator (400), the second simulator (400) being a simulator for a controlled device controlled by the controller, and the second execution result being a simulation execution result of an amount of a sampling interval of the second simulator (400); and
a synchronization step ((S4-1),(S4-2),(S8-1),(S8-2)) of outputting the first execution result acquired by the first acquisition step ((3), (7)) to the second simulator (400), and outputting the second execution result acquired by the second acquisition step ((1), (5)) to the first simulator (300), making the first simulator (300) and the second simulator (400) execute simulation periodically with the sampling interval respectively.

8. An information processing program, for making a computer function as the simulator linkage device (10) according to any of claims 1 to 6, wherein the information processing program is used for making the computer function as the portions.

9. A recording medium that records the information processing program according to claim 8 and is computer-readable.
